# EUROPÄISCHE PATENTANMELDUNG

(11) **EP 0 923 180 A2**
(43) Veröffentlichungstag der Anmeldung: **16.06.1999**
(21) Anmeldenummer: 98120614.7
(22) Anmeldetag: 02.11.1998
(51) Int. Cl.: H02H 5/04

(54) **Elektronischer Installationsschalter**

(30) Priorität: 11.12.1997 DE 19754981
(71) Anmelder: ABB PATENT GmbH, 68309 Mannheim (DE)
(72) Erfinder: Vollmann, Peter, Dipl.-Ing., 58091 Hagen (DE); Vogt, Friedrich, Dipl.-Ing., 58579 Schalksmühle (DE)
(74) Vertreter: Miller, Toivo

(57) **Zusammenfassung**

Die Erfindung bezieht sich auf einen elektronischen Installationsschalter (1), der eine integrierte Sicherungseinrichtung gegen Überlast enthält. Im Lastschalter (2) des Installationsschalters (1) ist ein Temperaturfühler (4) an einem laststromführenden Bauteil angeordnet. Eine Auswerte- und Ansteuerschaltung (5) löst bei einer mittels des Temperaturfühlers (4) detektierten Überlast eine Abschaltung des Lastschalters (2) aus.

## Beschreibung

Die Erfindung bezieht sich auf einen elektronischen Installationsschalter.

Elektronische Installationsschalter enthalten ein Relais oder Leistungshalbleiterbauelemente zur Laststromführung und eine elektronische Steuereinrichtung zur Ansteuerung einer Relaisspule oder eines Leistungshalbleiterbauelements.

Zahlreiche solche Installationsschalter, z. B. Jalousieschalter sind für einen Laststrom von z. B. 3 A oder 6 A, jedenfalls für einen Laststrom ausgelegt, der deutlich unter dem Nennstrom der in der Gebäudeinstallation üblichen Stromkreise liegt, die z. B. mit 16 A-Leitungsschutzschaltern abgesichert sind. Die Schalter müssen bei normgerechter Prüfung mit dem Auslösestrom der vorgeschalteten Sicherung geprüft werden. Hierbei dürfen vorgegebene Grenztemperaturen nicht überschritten werden.

Eine sicherheitstechnisch korrekte Installation macht in solchen Fällen die Anordnung einer Vorsicherung erforderlich, womit ein gewisser Aufwand verbunden ist. In der Praxis werden jedoch häufig elektronische Installationsschalter in zu hoch abgesicherten Stromkreisen betrieben.

Es ist bekannt, in Geräte, z. B. in Dimmer Schmelzsicherungen mit z. B. 1 A oder 2 A Nennstrom einzusetzen, die das Gerät vor einer Überlast schützen. Nachteilig ist allerdings, daß solche Sicherungen ausgetauscht werden müssen, um die Funktionsfähigkeit des Geräts nach Beseitigung der Überlastsituation wieder herzustellen. Elektronische Schalter, die als Lastschaltglied ein Relais verwenden, z.B. Jalousieschalter, Zeitschaltuhren etc. sind üblicher Weise nicht entsprechend ihrem Nennstrom abgesichert. Mit dem Auslösestrom der üblichen Absicherung des Stromkreises (16 A Leitungsschutzschalter) wird somit der elektronische Schalter möglicherweise thermisch überlastet.

Der Erfindung liegt die Aufgabe zugrunde, einen elektronischen Installationsschalter mit einer geräteeigenen Überlastsicherungseinrichtung anzugeben, die eine selbsttätige Rückstellung in den Betriebszustand ermöglicht.

Diese Aufgabe wird durch einen elektronischen Installationsschalter mit den im Anspruch 1 angegebenen Merkmalen gelöst.

Ein Vorteil des elektronischen Installationsschalters mit integrierter Sicherungseinrichtung besteht darin, daß er in bereits vorhandenen, an sich zu hoch abgesicherten Stromkreisen gefahrlos verwendet werden kann.

Eine weitere Erläuterung der Erfindung und vorteilhafter Ausgestaltungen erfolgt nachstehend anhand eines in der Zeichnung dargestellten Ausführungsbeispiels.

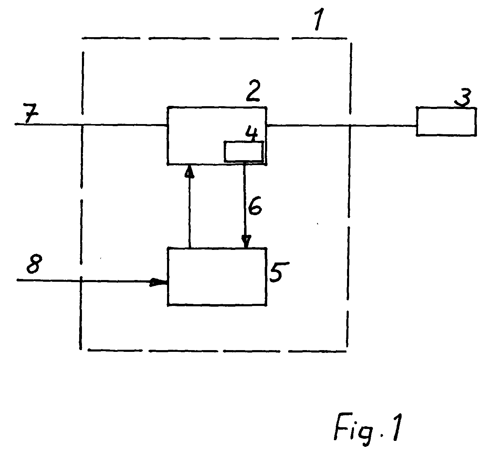

Fig. 1 zeigt ein Blockschema zu einem elektronischen Installationsschalter 1, an den eine Last 3 angeschlossen ist. Der elektronische Installationschalter 1 enthält einen Lastschalter 2, z. B. ein Relais oder Halbleiterschalter, mit dem die Last 3 mit einem Niederspannungsnetz 7 verbindbar ist.

Die Ansteuerung des Lastschalters 2 erfolgt durch eine Auswerte- und Ansteuerschaltung 5, der ein Schaltbefehl 8, z. B. von einem Steuergerät oder über ein Bussystem zuführbar ist.

Zur Überwachung bezüglich Überlast ist ein Temperaturfühler 4 im Lastschalter 2 angeordnet. Als Temperaturfühler ist z. B. ein PTC-Widerstand geeignet, der mit gut wärmeleitendem Kontakt zu einem laststromführenden Leiter oder einem vom Laststrom durchflossenen Bauteil, z. B. einen Leistungshalbleiterbauelement angeordnet ist. Da die Wärmeerzeugung in laststromführenden Teilen zum Laststrom korrespondiert, ist eine gute Überwachung gegeben.

Ein vom Temperaturfühler geliefertes Signal 6 wird von der Auswerte- und Ansteuerschaltung 5 ausgewertet und es wird von ihr bei detektierter Überlast eine Abschaltung des Lastschalters 2 veranlaßt.

Die Auswerte- und Ansteuerschaltung 5 kann vorzugsweise mit einer programmierbaren Einheit, z. B. einem Mikroprozessor ausgestattet werden, womit unterschiedliche Betriebsarten einstellbar sind. So kann beispielsweise festgelegt werden, ob die Last nach einiger Zeit selbsttätig wieder zugeschaltet werden soll, oder erst nach erneutem Einschaltbefehl oder nach einer Rückstellung der Schalterauslösung. Auch die Auslösecharakteristik ist wählbar.

## Patentansprüche

1. Elektronischer Installationsschalter (1) mit einem Lastschalter (2),
a) der durch eine Auswerte- und Ansteuerschaltung (5) ansteuerbar ist, der ein Schaltbefehl (8) zuführbar ist,
b) mit einem Temperaturfühler (4) der mit gutem Wärmekontakt an einem den Laststrom führenden Bauteil oder einer Leiterbahn des Lastschalters (2) angeordnet ist und dessen Signalleitung (6) an die Auswerte- und Ansteuerschaltung (5) angeschlossen ist, wobei die Auswerte- und Ansteuerschaltung (5) im Überlastfall eine Abschaltung des Lastschalters (2) bewirkt.

2. Elektronischer Installationsschalter nach Anspruch 1, dadurch gekennzeichnet, daß die Auswerte- und Ansteuerschaltung (5) eine programmierbare Einheit enthält, die unterschiedliche Betriebsarten ermöglicht.

3. Elektronischer Installationsschalter nach Anspruch 1 oder 2, dadurch gekennzeichnet, daß der Lastschalter (2) wenigstens ein Relais oder ein Leistungshalbleiterbauelement enthält.
